# EUROPEAN PATENT APPLICATION

(11) **EP 4 701 386 A1**
(43) Date of publication of application: **25.02.2026**
(21) Application number: 25184709.1
(22) Date of filing: 24.06.2025
(51) Int. Cl.: H10K 59/80

(54) **DISPLAY DEVICE**

(30) Priority: 20.08.2024 KR 20240110891
(71) Applicant: LG Display Co., Ltd., Seoul, 07336 (KR)
(72) Inventor: KIM, Kangil, 10845 Paju-si (KR); KIM, Jinhyeon, 10845 Paju-si (KR)
(74) Representative: Ter Meer Steinmeister & Partner

(57) **Abstract**

A display device includes a substrate including a first sub-pixel, a second sub-pixel, and a third sub-pixel; a first conductive layer including a first reflective electrode in the emissive area and the non-emissive area of the first sub-pixel on the substrate, and a first connection electrode in the non-emissive areas of the second and third sub-pixels; a second conductive layer including a second reflective electrode in the emissive area of the second sub-pixel above the first conductive layer; a third conductive layer including a third reflective electrode in the emissive area and the non-emissive area of the third sub-pixel above the second conductive layer, and a second connection electrode in the non-emissive areas of the first and second sub-pixels; and anode electrodes respectively disposed on the first, the second, and the third conductive layer in the first to third sub-pixels. In the non-emissive area of the first sub-pixel, the second connection electrode is connected to the first reflective electrode, in the non-emissive area of the second sub-pixel, the second connection electrode is connected to the first connection electrode, and in the non-emissive area of the third sub-pixel, the third reflective electrode is connected to the first connection electrode.

## Description

The present application claims priority to Korean Patent Application No. 10-2024-0110891, filed August 20, 2024.

### FIELD OF THE INVENTION

The present specification relates to a display device.

### BACKGROUND OF THE INVENTION

With the advancement of the information society, there is an increasing demand for display devices that can show images, and various types of display devices such as liquid crystal display (LCD) devices and organic light emitting device (OLED) displays are being utilized.

Among display devices, OLED displays are self-emissive, offering superior viewing angles and contrast ratios compared to LCDs, while eliminating the need for a separate backlight, enabling a lightweight and slim design with advantageous power consumption. Furthermore, OLED displays support low-voltage DC operation, feature fast response times, and, most notably, offer the advantage of lower manufacturing costs.

Recently, there has been a growing demand for OLED displays that cater to the requirements of augmented reality (AR), virtual reality (VR), and ultra-high-resolution display devices of comparable quality.

### SUMMARY OF THE INVENTION

It is an object of the present specification to provide a display device capable of expanding the emissive area.

It is another object of the present specification to provide a display device capable of minimizing the step difference in the contact portion by reducing the number of reflective electrodes or connection electrodes overlapping with transistors in the contact portion.

It is still another object of the present specification to provide a display device capable of improving the light efficiency and color deviation of the organic light-emitting device by mitigating the thickness variation of the common light-emitting layer on the contact portion through minimizing the step difference in the contact portion. One or more of these objects are solved by the features of the appended independent claim(s).

The objects of the present specification are not limited to the aforementioned, and other technical objectives may be inferred from the following embodiments.

According to one aspect, a display device includes a substrate including a first sub-pixel, a second sub-pixel, and a third sub-pixel, each including an emissive area and a non-emissive area surrounding the emissive area; a first conductive layer including a first reflective electrode in the emissive area and the non-emissive area of the first sub-pixel on the substrate, and first connection electrodes in the non-emissive areas of the second and third sub-pixels; a second conductive layer including a second reflective electrode in the emissive area of the second sub-pixel on the first conductive layer; a third conductive layer including a third reflective electrode in the emissive area and the non-emissive area of the third sub-pixel on the second conductive layer, and a second connection electrode in the non-emissive areas of the first and second sub-pixels; and anode electrodes disposed on the third conductive layer in the first, second and third sub-pixels. In the non-emissive area of the first sub-pixel, the second connection electrode may be connected to the first reflective electrode; in the non-emissive area of the second sub-pixel, the second connection electrode may be connected to the first connection electrode; and/or in the non-emissive area of the third sub-pixel, the third reflective electrode may be connected to the first connection electrode.

According to another aspect, a display device includes a substrate including a first sub-pixel, a second sub-pixel, and a third sub-pixel, each including an emissive area and a non-emissive area surrounding the emissive area; a first conductive layer including a first reflective electrode in the emissive area and the non-emissive area of the first sub-pixel on the substrate, and a first connection electrode in the non-emissive areas of the second and third sub-pixels; a second conductive layer including a second reflective electrode in the emissive area of the second sub-pixel on the first conductive layer; a third conductive layer including a third reflective electrode in the emissive area and the non-emissive area of the third sub-pixel on the second conductive layer, and a second connection electrode in the non-emissive areas of the first and second sub-pixels; and anode electrodes respectively disposed on the first, the second, and the third conductive layers in the first, second and third sub-pixels. In the non-emissive area of the first sub-pixel, the second connection electrode is connected to the first reflective electrode, in the non-emissive area of the second sub-pixel, the second connection electrode is connected to the first connection electrode, and in the non-emissive area of the third sub-pixel, the third reflective electrode is connected to the first connection electrode.

According to another aspect, a display device includes a substrate including a first sub-pixel, a second sub-pixel, and a third sub-pixel, each including an emissive area and a non-emissive area surrounding the emissive area; a first conductive layer including a first reflective electrode in the emissive area and the non-emissive area of the first sub-pixel on the substrate, and a first connection electrode respectively in the non-emissive areas of the second and third sub-pixels; a second conductive layer including a second reflective electrode in the emissive area of the second sub-pixel on the first conductive layer; a third conductive layer including a third reflective electrode in the emissive area and the non-emissive area of the third sub-pixel on the second conductive layer; and anode electrodes respectively disposed on the third conductive layer in the first, second and third sub-pixels. The third conductive layer may include a second connection electrode in the non-emissive areas of the first and second sub-pixels. In the non-emissive area of the first sub-pixel, the anode electrode or the second connection electrode may be (directly) connected to and/or in contact with the first reflective electrode. In the non-emissive area of the second sub-pixel, the anode electrode or the second connection electrode may be (directly) connected to and/or in contact with the first connection electrode. In the non-emissive area of the third sub-pixel, the third reflective electrode may be (directly) connected to and/or in contact with the first connection electrode.

The display device according to any one of these aspects may include one or more of the following features:

In the non-emissive area of the first sub-pixel, the second connection electrode may be directly connected to the first reflective electrode. In the non-emissive area of the second sub-pixel, the second connection electrode may be directly connected to the first connection electrode. In the non-emissive area of the third sub-pixel, the third reflective electrode may be directly connected to the first connection electrode. In the non-emissive areas of the first sub-pixel and the second sub-pixel, the anode electrode may be directly disposed on the second connection electrode. In the emissive area and the non-emissive area of the third sub-pixel, the anode electrode may be directly disposed on and/or directly connected to the third reflective electrode. The second reflective electrode may be floating. The second reflective electrode may be applied with a fixed voltage. The display device may include a display area in which the first, second and third sub-pixels are disposed, a non-display area surrounding the display area. A low-potential voltage line may be disposed in the non-display area. The second reflective electrode may be electrically connected to the low-potential voltage line. The first, second and third sub-pixels may be arranged along a first direction. Each of the first, second and third sub-pixels may be repeatedly disposed along a second direction intersecting the first direction. Adjacent second sub-pixels in the second direction may share the second reflective electrode. The second reflective electrode may not overlap with the first connection electrode and/or the second connection electrode. In the second sub-pixel, the second reflective electrode may overlap with the first connection electrode. The second reflective electrode may be connected to and/or disposed in contact with the first connection electrode. The display device may include a common light-emitting layer disposed on the anode electrodes in the first, second and third sub-pixels. The common light-emitting layer may be physically separated at boundaries between adjacent sub-pixels.

According to another aspect, a display device includes a substrate including a first sub-pixel, a second sub-pixel, and a third sub-pixel, each including an emissive area and a non-emissive area surrounding the emissive area; a first conductive layer including a first reflective electrode in the emissive area and the non-emissive area of the first sub-pixel on the substrate, and first connection electrodes in the non-emissive areas of the second and third sub-pixels; a second conductive layer including a second reflective electrode in the emissive area of the second sub-pixel on the first conductive layer; a third conductive layer including a third reflective electrode in the emissive area and the non-emissive area of the third sub-pixel on the second conductive layer; and anode electrodes respectively disposed on the first, second and third conductive layers in the first, second and third sub-pixels. In the non-emissive area of the first sub-pixel, the anode electrode is directly connected to the first reflective electrode, in the non-emissive area of the second sub-pixel, the anode electrode is directly connected to the first connection electrode, and in the non-emissive area of the third sub-pixel, the third reflective electrode is directly connected to the first connection electrode.

In the emissive area and the non-emissive area of the third sub-pixel, the anode electrode may be directly disposed on the third reflective electrode. The second reflective electrode may be floating. The second reflective electrode may be applied with a fixed voltage. The display device may include a display area in which the first, second and third sub-pixels are disposed, a non-display area surrounding the display area. A low-potential voltage line may be disposed in the non-display area. The second reflective electrode may be electrically connected to the low-potential voltage line. The first, second and third sub-pixels may be arranged along a first direction. Each of the first, second and third sub-pixels may be repeatedly disposed along a second direction intersecting the first direction. Adjacent second sub-pixels in the second direction may share the second reflective electrode. The second reflective electrode may not overlap with the first connection electrode. In the second sub-pixel, the second reflective electrode may overlap with the first connection electrode. The second reflective electrode may be connected to the first connection electrode. In the second sub-pixel, the second reflective electrode may overlap with the first connection electrode. The second reflective electrode may be connected to the first connection electrode. The display device may include a common light-emitting layer disposed on the anode electrodes in the first, second and third sub-pixels. The common light-emitting layer may be physically separated at boundaries between adjacent sub-pixels.

It is noted that "disposed on" may mean "disposed directly on" or "disposed in contact with" as well as "disposed indirectly on" or "disposed above" or "disposed with other layers in between on" in the present disclosure. However, "directly connected" may be understood as "in (electric and/or physical) contact with".

The specific details of other embodiments are included in the detailed description and drawings.

### BRIEF DESCRIPTION OF THE DRAWINGS

FIG. 1 is a plan view of a display device according to an embodiment;
FIG. 2 is a cross-sectional view taken along line A-A' of FIG. 1;
FIG. 3 is a plan view illustrating the substrate, connection film, and printed circuit board of FIG. 1;
FIG. 4 is a circuit diagram of a pixel according to an embodiment;
FIG. 5 is a plan view of the pixel of FIG. 1;
FIG. 6 is a cross-sectional view taken along line B-B' of FIG. 5.
FIG. 7 is a cross-sectional view taken along line C-C' of FIG. 5.
FIG. 8 is a cross-sectional view of the organic light-emitting device of FIG. 6.
FIG. 9 is a cross-sectional view of the organic light-emitting device of FIG. 6 according to an alternative embodiment;
FIG. 10 is a plan view of a pixel according to another embodiment;
FIG. 11 is a plan view of a pixel according to another embodiment;
FIG. 12 is a cross-sectional view taken along line D-D' of FIG. 11;
FIG. 13 is a plan view of a pixel according to another embodiment;
FIG. 14 is a cross-sectional view taken along line E-E' of FIG. 13;
FIG. 15 is a cross-sectional view of a display device according to another embodiment; and
FIG. 16 is a cross-sectional view of a display device according to another embodiment.

### DETAILED DESCRIPTION OF THE INVENTION

Hereinafter, embodiments are described with reference to accompanying drawings. In the specification, when a component (or area, layer, part, etc.) is mentioned as being "on," "on top of," "connected to," or "coupled to" another component, it means that it may be directly on the other component or directly connected/coupled to the other component, or a third component may be placed between them, respectively. The term "above" may refer, e.g., to an electrode or layer, being placed at a higher position or level than, e.g., another electrode or layer.

The same reference numerals refer to the same components. In addition, in the drawings, the thickness, proportions, and dimensions of the components are exaggerated for effective description of the technical content. The expression "and/or" is taken to include one or more combinations that can be defined by associated components.

The terms "first," "second," etc. are used to describe various components, but the components should not be limited by these terms. The terms are used only for distinguishing one component from another component. For example, a first component may be referred to as a second component and, similarly, the second component may be referred to as the first component, without departing from the scope of the appended claims. The singular forms are intended to include the plural forms as well unless the context clearly indicates otherwise.

The terms such as "below," "lower," "above," "upper," etc. are used to describe the relationship of components depicted in the drawings. The terms are relative concepts and are described based on the direction indicated on the drawing.

It will be further understood that the terms "comprises," "has," and the like are intended to specify the presence of stated features, numbers, steps, operations, components, parts, or a combination thereof but are not intended to preclude the presence or possibility of one or more other features, numbers, steps, operations, components, parts, or combinations thereof.

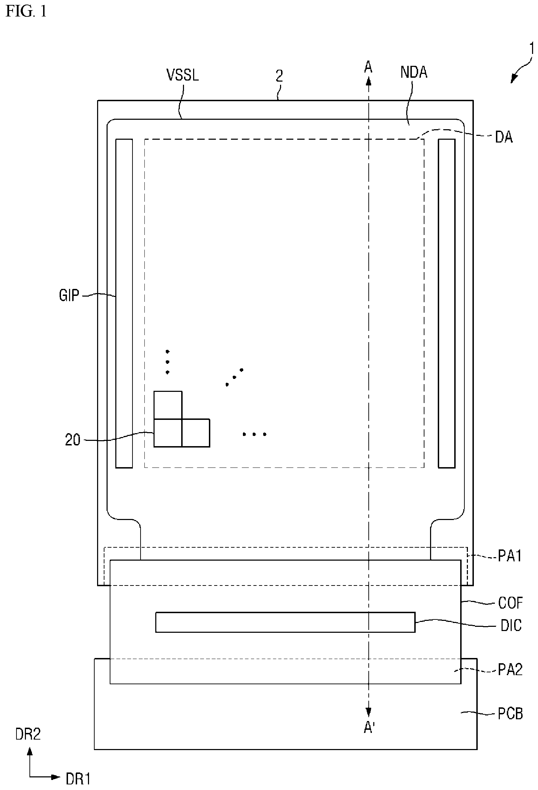

FIG. 1 is a plan view of a display device according to an embodiment.

Referring to FIG. 1, a display device 1 according to an embodiment may include a substrate 2 comprising a display area DA that includes a plurality of pixels 20 and a non-display area NDA surrounding the display area DA. The non-display area NDA may surround the display area DA and may be a region that does not include pixels 20 and does not generate images; however, the embodiments of the present specification are not limited to this. The non-display area NDA may include a first pad area PA1 located on the opposite side of the second direction DR2 of the display area DA.

A gate driver GIP may be disposed in the non-display area NDA on one side and the opposite side of the display area DA in the first direction DR1. The gate driver GIP may be formed in the form of an integrated circuit on the substrate 2, but is not limited to this and may also be formed in the form of a driving chip. In FIG. 1, gate drivers GIP are illustrated on both sides of the display area DA, but the embodiments are not limited to this, and the gate driver GIP may be disposed on only one side, either left or right.

A connection film COF may be attached to the first pad area PA1. The data driver DIC may be disposed on the connection film COF. The data driver DIC may be provided in the form of a driving chip, but the embodiments of the present specification are not limited thereto. One end of the connection film COF may be connected to the first pad area PA1, and the other end may include a second pad area PA2. A printed circuit board PCB may be connected to the second pad area PA2 of the connection film COF.

A low-potential voltage line VSSL may be disposed in the non-display area NDA. One end and the other end of the low-potential voltage line VSSL may be connected to the connection film COF and may surround the display area DA from the outside of the gate driver GIP.

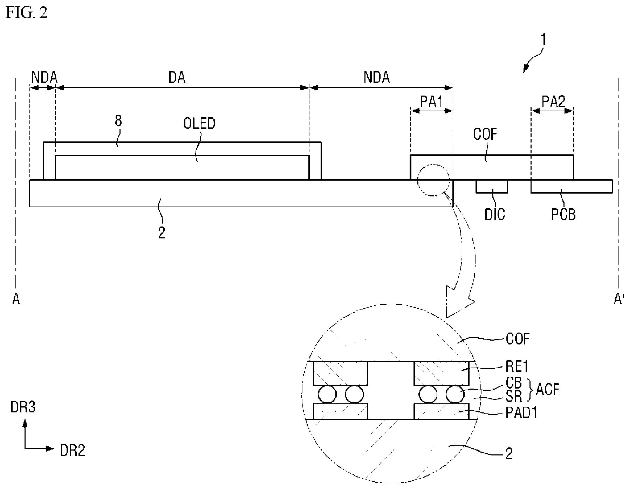

FIG. 2 is a cross-sectional view taken along line A-A' of FIG. 1. For convenience of explanation, FIG. 2 illustrates only the organic light-emitting device OLED on the substrate 2 of the display device 1 and the encapsulation layer 8 encapsulating the organic light-emitting device OLED.

Referring to FIG. 2, a connection film COF may be attached to the first pad area PA1 of the substrate 2. A data driver DIC may be disposed on the connection film COF. Although FIG. 2 illustrates the data driver DIC disposed on the lower surface of the connection film COF, the embodiments are not limited to this, and the data driver DIC may be disposed on the upper surface of the connection film COF.

The non-display area NDA surrounding the display area DA may be a bezel area.

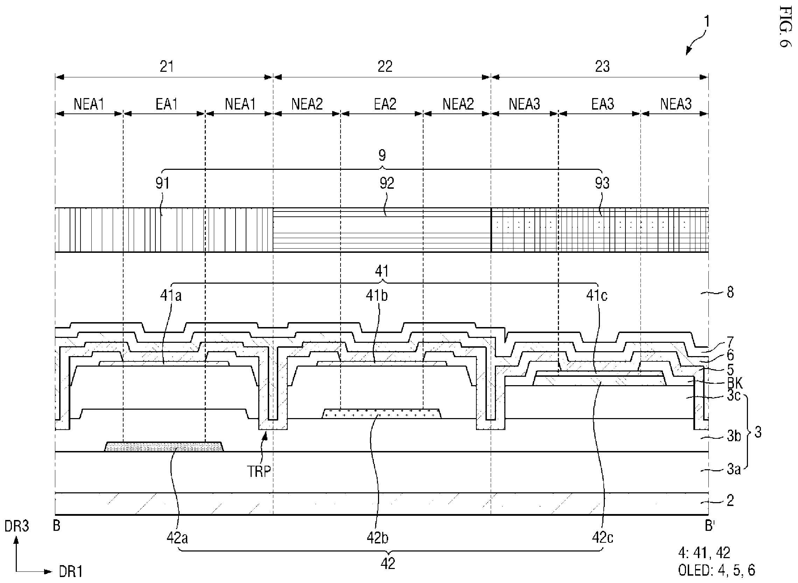

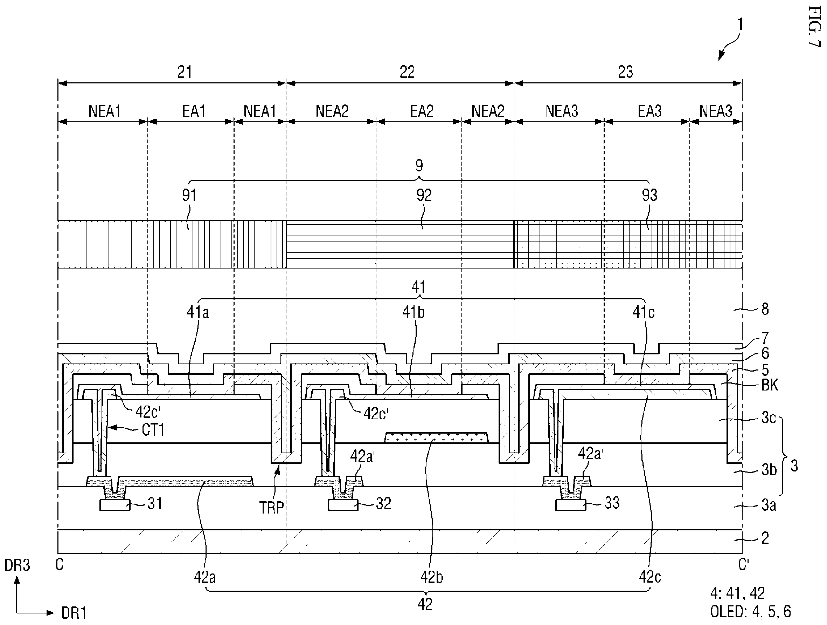

The display device 1 may further include a first pad PAD1 in the first pad area PA1. The first pad PAD1 may be disposed on the same layer as one of the conductive layers of the thin-film transistors 31, 32, and 33 illustrated in FIG. 6 or FIG. 7, one of the reflective electrodes 42a, 42b, and 42c, or one of the anode electrodes 41a, 41b, and 41c; however, the embodiments of the present specification are not limited thereto.

A lead electrode may be disposed on the lower surface of the connection film COF. Among the lead electrodes, the first lead electrode RE1 is illustrated. An anisotropic conductive film ACF may be disposed between the first lead electrode RE1 and the first pad PAD1. The anisotropic conductive film ACF may include conductive balls CB dispersed in resin SR. The resin SR may include an organic material with adhesive properties. The first pad PAD1 and the first lead electrode RE1 may be electrically connected with the conductive balls CB in between. The resin SR may contact the side surfaces and lower surface of the first lead electrode RE1 and the side surfaces and upper surface of the first pad PAD1, acting to bond the first pad PAD1 and the first lead electrode RE1.

A printed circuit board PCB may be connected to the second pad area PA2 of the connection film COF.

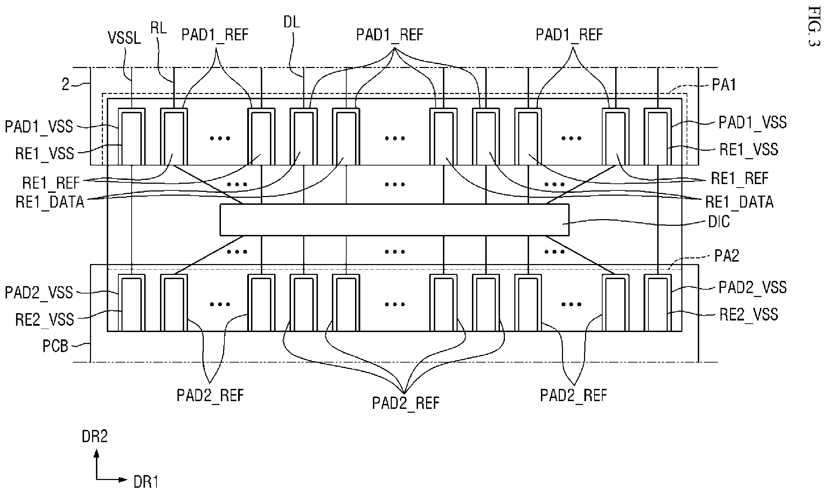

FIG. 3 is a plan view illustrating the substrate, connection film, and printed circuit board of FIG. 1.

Referring to FIG. 3, the substrate 2 may include a first pad area PA1, and the first pad area PA1 may have a plurality of first pads disposed thereon. The first pads may include a first low-voltage pad PAD1_VSS, a first reference voltage pad PAD1_REF, a first data pad PAD 1_DATA, etc., but the embodiments of the present specification are not limited thereto.

One end of the connection film COF may be connected to the first pad area PA1. A plurality of first lead electrodes may be disposed at one end of the connection film COF. The first lead electrodes may include a first low-voltage lead electrode RE1 _VSS, a first reference voltage lead electrode RE1_REF, a first data lead electrode RE1 _DATA, etc., but the embodiments of the present specification are not limited thereto. The first low-voltage lead electrode RE1_ VSS and the first low-voltage pad PAD1 _VSS may be electrically connected, the first reference voltage lead electrode RE1_REF and the first reference voltage pad PAD 1_REF may be electrically connected, and the first data lead electrode RE1_DATA and the first data pad PAD1 _DATA may be electrically connected.

The data driver DIC may be disposed on the connection film COF. The first low-voltage lead electrode RE1_VSS, the first reference voltage lead electrode RE1_REF, and the first data lead electrode RE1_DATA may each be electrically connected to the data driver DIC.

The other end of the connection film COF may be connected to the second pad area PA2. The printed circuit board PCB may include the second pad area PA2 and may be connected to the other end of the connection film COF. A plurality of second lead electrodes may be disposed at the other end of the connection film COF. The second lead electrodes may include a second low-voltage lead electrode RE2_VSS, a second reference voltage lead electrode RE2_REF, a second data lead electrode RE2_DATA, etc., but the embodiments of the present specification are not limited thereto.

A plurality of second pads may be disposed in the second pad area PA2. The second pads may include a second low-voltage pad PAD2_VSS, a second reference voltage pad PAD2_REF, a second data pad PAD2 _DATA, etc., but the embodiments of the present specification are not limited thereto.

The second low-voltage lead electrode RE2_VSS and the second low-voltage pad PAD2_VSS may be electrically connected, the second reference voltage lead electrode RE2_REF and the second reference voltage pad PAD2_REF may be electrically connected, and the second data lead electrode RE2_DATA and the second data pad PAD2 _DATA may be electrically connected.

The second low-voltage lead electrode RE2_VSS, the second reference voltage lead electrode RE2_REF, and the second data lead electrode RE2_DATA may each be electrically connected to the data driver DIC.

The first low-voltage pad PAD 1_VSS may be electrically connected to the low-voltage line VSSL, the first reference voltage pad PAD1_REF may be electrically connected to the reference voltage line RL, and the first data pad PAD1_DATA may be electrically connected to the data line DL.

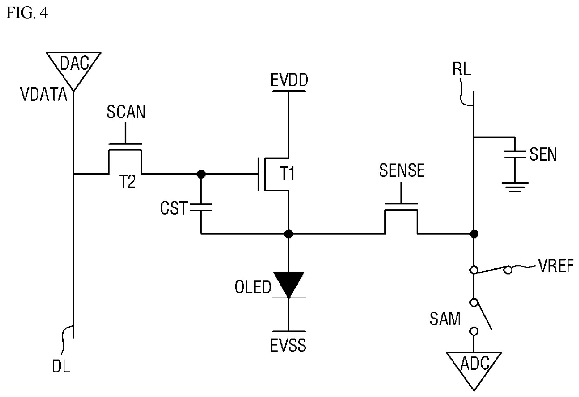

FIG. 4 is a circuit diagram of a pixel according to an embodiment.

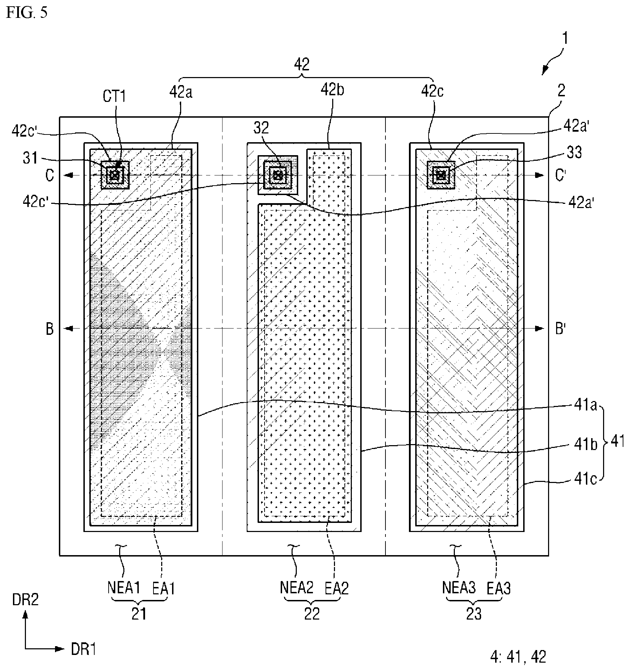

FIG. 4 shows the circuit diagram of a pixel 20 according to an embodiment, and the circuit diagram of each sub-pixel 21, 22, and 23 in FIG. 5 is the same as that of the pixel 20 in FIG. 4.

Each sub-pixel may receive the data voltage VDATA through a digital-to-analog converter DAC. The sensing voltage VSEN output from each sub-pixel is provided to an analog-to-digital converter (ADC). High-potential voltage EVDD and low-potential voltage EVSS may be applied to each sub-pixel.

Each sub-pixel includes a scan transistor T2, a driving transistor T1, and a sensing transistor T3. Additionally, each sub-pixel includes a storage capacitor CST and an organic light-emitting device OLED.

The first electrode (e.g., the drain electrode) of the scan transistor T2 is connected to the data line DL, where the data voltage VDATA is provided. The data voltage VDATA is output from the data driver DIC (FIG. 3) and applied to the data line DL through the DAC. The second electrode (e.g., the source electrode) of the scan transistor T2 is connected to one end of the storage capacitor CST and the gate electrode of the driving transistor T1. The gate electrode of the scan transistor T2 is connected to the scan line, where the scan signal SCAN is applied. That is, the scan transistor T2 is turned on when a gate signal at the gate-on level is applied through the scan signal SCAN, and the data voltage VDATA applied through the data line DL is transferred to one end of the storage capacitor CST.

One end of the storage capacitor CST is connected to the second electrode of the scan transistor T2. The other end of the storage capacitor CST is connected to the second electrode (e.g., the drain electrode) of the sensing transistor T3 and the second electrode of the driving transistor T1. The storage capacitor CST may charge a voltage corresponding to the difference between the voltage applied to one end and the reference voltage VREF applied to the other end through the switch SPRE and the sensing transistor T3. The reference voltage VREF is applied to the reference voltage line RL.

The first electrode (e.g., the drain electrode) of the driving transistor T1 is configured to receive the high-potential voltage EVDD, and the second electrode (e.g., the source electrode) is connected to the first electrode (e.g., the anode electrode) of the organic light-emitting device OLED. The third electrode (e.g., the gate electrode) of the driving transistor T1 is connected to one end of the storage capacitor CST. The driving transistor T1 may control the amount of driving current flowing through the organic light-emitting device OLED in response to the voltage provided to the gate electrode. That is, the current applied to the organic light-emitting device OLED is determined by the voltage difference in the gate-source voltage Vgs of the driving transistor T1 (or the stored voltage of the storage capacitor CST).

The first electrode (e.g., the source electrode) of the sensing transistor T3 is connected to the reference voltage line RL, the second electrode (e.g., the drain electrode) is connected to the other end of the storage capacitor CST, and the third electrode (e.g., the gate electrode) is applied with the sensing signal SENSE. That is, the sensing transistor T3 is turned on by the sensing signal SENSE output from the gate driver (refer to GIP in FIG. 1), and applies the reference voltage VREF to the other end of the storage capacitor CST. When both the switch SPRE and the switch SAM are turned off, and the sensing transistor T3 is turned on, the stored voltage of the storage capacitor CST may be transferred to the capacitor connected to the reference voltage line RL, and the sensing voltage VSEN is stored in the capacitor of the reference voltage line RL.

When the switch SPRE is turned off and the switch SAM is turned on, the sensing voltage VSEN may be output to the data driver (refer to DIC in FIG. 3) through the analog-to-digital converter ADC.

FIG. 5 is a plan view of the pixel of FIG. 1. FIG. 6 is a cross-sectional view taken along line B-B' of FIG. 5. FIG. 7 is a cross-sectional view taken along line C-C' of FIG. 5.

Referring to FIGS. 5 to 7, the display device 1 according to an embodiment includes a substrate 2, a first electrode 4, a common light-emitting layer 5, and a cathode electrode 6.

A plurality of sub-pixels 21, 22, and 23 are formed on the substrate 2. The plurality of sub-pixels 21, 22, and 23 may constitute a single pixel 20 (FIG. 1). A plurality of panel pixels may be formed on the substrate 2.

The plurality of sub-pixels 21, 22, and 23 includes the first sub-pixel 21, the second sub-pixel 22, and the third sub-pixel 23. By arranging the first sub-pixel 21, the second sub-pixel 22, and the third sub-pixel 23 in order, the second sub-pixel 22 may be adj acent to one side, for example the right side, of the first sub-pixel 21, and the third sub-pixel 23 may be adjacent to one side, for example the right side, of the second sub-pixel 22.

Throughout this specification, the phrase "two sub-pixels are arranged adjacent to each other" should be interpreted to mean that no other sub-pixel is placed between the two sub-pixels.

The first sub-pixel 21 may be configured to emit red (R) light, the second sub-pixel 22 may be configured to emit green (G) light, and the third sub-pixel 23 may be configured to emit blue (B) light, although this is not necessarily limited to these colors.

In FIG. 5, the pixel is shown as including only three sub-pixels 21, 22, and 23, but it is not limited to this configuration, and the pixel may include four sub-pixels. When the pixel includes four sub-pixels, a fourth sub-pixel configured to emit white (W) light may be further included.

The first to third sub-pixels 21, 22, and 23 may each be configured with the same size. For example, the first to third sub-pixels 21, 22, and 23 may each be configured to have the same width and height. Here, the width may refer to the horizontal direction (first direction DR1) based on FIG. 1, and the height may refer to the direction perpendicular to the width (second direction DR2) based on FIG. 1, though the embodiments of this specification are not limited thereto.

Each sub-pixel 21, 22, and 23 may include an emissive area (EA1, EA2, EA3) and a non-emissive area (NEA1, NEA2, NEA3). The first sub-pixel 21 may include a first emissive area EA1 and a first non-emissive area NEA1 surrounding the first emissive area EA1, the second sub-pixel 22 may include a second emissive area EA2 and a second non-emissive area NEA2 surrounding the second emissive area EA2, and the third sub-pixel 23 may include a third emissive area EA3 and a third non-emissive area NEA3 surrounding the third emissive area EA3. The emissive areas EA1, EA2, and EA3 may correspond to the areas exposed by the bank BK of the anode electrodes 41a, 41b, and 41c described later, but the embodiments of this specification are not limited thereto.

The first electrode 4 is patterned for each individual panel sub-pixel 21, 22, and 23. That is, a single first electrode 4 is formed in the first sub-pixel 21, another first electrode 4 is formed in the second sub-pixel 22, and yet another first electrode 4 is formed in the third sub-pixel 23. The first electrode 4 may function as the anode of the display device 1. The first electrode 4 may include a reflective electrode and an anode electrode. The anode electrode 41 and the reflective electrode 42 may be disposed for each sub-pixel 21, 22, and 23. The anode electrode 41 includes a first anode electrode 41a disposed in the first sub-pixel 21, a second anode electrode 41b disposed in the second sub-pixel 22, and a third anode electrode 41c disposed in the third sub-pixel 23, while the reflective electrode 42 may include a first reflective electrode 42a disposed in the first sub-pixel 21, a second reflective electrode 42b disposed in the second sub-pixel 22, and a third reflective electrode 42c disposed in the third sub-pixel 23.

Each anode electrode 41a, 41b, and 41c may have a bank BK disposed thereon, as described later. The bank BK may be configured to cover the edges of the anode electrodes 41a, 41b, and 41c disposed in the first to third sub-pixels 21, 22, and 23, thereby distinguishing the first sub-pixel 21, the second sub-pixel 22, and the third sub-pixel 23. The bank BK may be disposed in the non-emissive areas NEA1, NEA2, and NEA3.

The display device 1 includes reflective electrodes 42a, 42b, and 42c with different surface heights for the respective sub-pixels 21, 22, and 23, thereby further improving light extraction efficiency by utilizing microcavity characteristics.

The microcavity characteristic refers to the phenomenon where, when the distance between the reflective electrodes 42a, 42b, and 42c and the cathode electrode 6 is an integer multiple of half the wavelength (λ/2) of the light emitted from the sub-pixels 21, 22, and 23, constructive interference occurs, amplifying the light, and the repeated reflection and re-reflection process between the reflective electrodes 42a, 42b, and 42c and the cathode electrode 6 continuously increases the amplification, thereby improving the external light extraction efficiency.

The common light-emitting layer 5 may be configured to emit white light. For example, the common light-emitting layer 5 may be configured as a 2-stack structure including a blue light-emitting layer, a yellow-green light-emitting layer, and a charge generation layer, or as a 3-stack structure including a blue light-emitting layer, a green light-emitting layer, a red light-emitting layer, and a charge generation layer to emit white light, but is not limited to these configurations and may be provided with a plurality of layers exceeding three stacks as possible as it is capable of emitting white light.

The common light-emitting layer 5 may be formed as a common layer extending across the entire first to third panel sub-pixels 21, 22, and 23.

The cathode electrode 6 is used to form an electric field with the anode electrodes 41a, 41b, and 41c and may function as a cathode. The cathode electrode 6 is disposed on the upper surface of the common light-emitting layer 5, opposite to the lower surface where the anode electrodes 41a, 41b, and 41c are in contact, and may be provided as a common layer across the entire first to third sub-pixels 21, 22, and 23.

In the case of a top emission configuration, the cathode electrode 6 may be provided as a second electrode, but in the case of a bottom emission method, it may be provided as a first electrode including a reflective material. In the case of an top emission configuration, the cathode electrode 6 may be formed as a semi-transparent electrode to enhance light extraction efficiency using microcavity characteristics. The display device 1 utilizes microcavity characteristics in the top emission configuration to improve light extraction efficiency, which is why the cathode electrode 6 is formed as a semi-transparent electrode, as an example.

The color filter layer 9 is provided on each of the first to third sub-pixels 21, 22, and 23 to block predetermined colors from the light emitted by the common light-emitting layer 5 of each sub-pixel 21, 22, and 23. The first color filter 91 provided in the first sub-pixel 21 may be configured to block all colors except for red (R) light. In this case, the first color filter 91 may be a red color filter. The second color filter 92 provided in the second sub-pixel 22 may be configured to block all colors except for green (G) light. In this case, the second color filter 92 may be a green color filter. The third color filter 93 provided in the third sub-pixel 23 may be configured to block all colors except for blue (B) light. In this case, the third color filter 93 may be a blue color filter. However, the embodiments of this specification are not limited thereto.

The first to third color filters 91, 92, and 93 provided in each of the first to third sub-pixels 21, 22, and 23 may be configured to have the same size as the respective sub-pixels or may be scaled up or down by a certain ratio of the size of each sub-pixel.

Transistors 31, 32, and 33 may be disposed in the non-emissive areas NEA1, NEA2, and NEA3 of each sub-pixel 21, 22, and 23. For example, transistors 31, 32, and 33 may overlap with the reflective electrodes 42a, 42b, and 42c disposed in each sub-pixel 21, 22, and 23. Transistors 31, 32, and 33 may be electrically connected to the reflective electrodes 42a, 42b, and 42c.

Hereinafter, a detailed description of the laminated structure of the display device 1 according to an embodiment is provided.

The display device 1 according to an embodiment includes a substrate 2, an insulating layer 3, a first electrode 4, a bank BK, a common light-emitting layer 5, a cathode electrode 6, a capping layer 7, an encapsulation layer 8, and a color filter layer 9.

The substrate 2 may be made of a semiconductor material such as plastic film, glass substrate, or silicon.

The substrate 2 may be made of transparent or opaque materials. Sub-pixels 21, 22, and 23 are provided on the substrate 2. The first sub-pixel 21 may emit red (R) light, the second sub-pixel 22 may emit blue (B) light, and the third sub-pixel 23 may emit green (G) light.

In an embodiment, the display device 1 is configured in a so-called top emission method where the emitted light is released upwards, and therefore, the material of the substrate 2 may be either a transparent material or an opaque material. On the upper side of the first to third sub-pixels 21, 22, and 23, color filters 91, 92, and 93 may be provided to transmit light of the respective colors as mentioned above.

The insulating layer 3 is formed on the substrate 2. The insulating layer 3 may include an inorganic insulating material. The insulating layer 3 may include a first insulating layer 3a, a second insulating layer 3b on the first insulating layer 3a, and a third insulating layer 3c on the second insulating layer 3b.

The insulating layer 3 includes circuit elements such as multiple thin-film transistors 31, 32, and 33, various signal lines, and capacitors, provided for each sub-pixel 21, 22, and 23. The first insulating layer 3a may have thin-film transistors 31, 32, and 33 arranged therein. The signal lines may include gate lines, data lines, power lines, and reference voltage lines, and the thin-film transistors 31, 32, and 33 may include switching transistors, driving transistors, and sensing transistors. Each of the sub-pixels 21, 22, and 23 is defined by the intersection structure of the gate lines and data lines. The insulating layer 3 may surround the thin-film transistors 31, 32, and 33.

The switching transistor switches according to the gate signal supplied to the gate line to supply the data voltage from the data line to the driving transistor.

The driving transistor switches according to the data voltage supplied from the switching transistor, generating data current from the power supplied through the power line, which is then supplied to the first electrode 4.

The sensing transistor serves to sense the threshold voltage deviation of the driving transistor, which causes image quality degradation, and, in response to a sensing control signal supplied from the gate line or a separate sensing line, supplies the current of the driving transistor to the reference voltage line.

The capacitor serves to maintain the data voltage supplied to the driving transistor for one frame and is connected to the gate terminal and source terminal of the driving transistor, respectively.

The first thin-film transistor 31, the second thin-film transistor 32, and the third thin-film transistor 33 are arranged in the first insulating layer 3a for each individual sub-pixel 21, 22, and 23. The first thin-film transistor 31 is connected to the first electrode 4 disposed on the first sub-pixel 21 and may apply a driving voltage to emit light of the color corresponding to the first sub-pixel 21. The first thin-film transistor 31, second thin-film transistor 32, and third thin-film transistor 33 may be located in the same thin-film transistor layer, but the embodiments in this specification are not limited to this.

The second thin-film transistor 32 is connected to the first electrode 4 disposed on the second sub-pixel 22 and may apply a driving voltage to emit light of the color corresponding to the second sub-pixel 22.

The third thin-film transistor 33 is connected to the first electrode 4 disposed on the third sub-pixel 23 and may apply a driving voltage to emit light of the color corresponding to the third sub-pixel 23.

Each of the first sub-pixel 21, the second sub-pixel 22, and the third sub-pixel 23 supplies a predetermined current to the light-emitting layer according to the data voltage of the data line when a gate signal (or scan signal) is input from the gate line (or scan line) using their respective transistors 31, 32, and 33. As a result, the light-emitting layers of the first sub-pixel 21, second sub-pixel 22, and third sub-pixel 23 may emit light at a predetermined brightness according to the supplied current.

The insulating layer 3 may protect the transistors 31, 32, and 33. The insulating layer 3 may be made of an inorganic insulating material, but it is not limited to this, and can also be made of an organic insulating material. For example, the insulating layer 3 may be made of an inorganic material such as silicon nitride (SiNx), silicon oxide (SiOx), or aluminum oxide (Al₂O₃), but the embodiments in this specification are not limited to these materials. The first insulating layer 3a, the second insulating layer 3b, and the third insulating layer 3c may be made of inorganic materials such as silicon nitride (SiNx), silicon oxide (SiOx), or aluminum oxide (Al₂O₃), but the embodiments of this specification are not limited thereto.

A plurality of reflective electrode layers may be arranged on the insulating layer 3. The reflective electrode layers may include a first reflective electrode layer on the first insulating layer 3a, a second reflective electrode layer on the second insulating layer 3b, and a third reflective electrode layer on the third insulating layer 3c. The first reflective electrode layer may include a first reflective electrode 42a and a first connection electrode 42a', the second reflective electrode layer may include a second reflective electrode 42b, and the third reflective electrode layer may include a third reflective electrode 42c and a second connection electrode 42c'. The first reflective electrode 42a and the first connection electrode 42a' may be arranged in the same layer and may include the same material. The third reflective electrode 42c and the second connection electrode 42c' may be disposed in the same layer and may include the same material.

Each reflective electrode layer may include a reflective material to reflect light. For example, the reflective material may be metal, but it is not limited to this, and any other material capable of reflecting light may also be used. For example, the reflective material may include aluminum (Al) or silver (Ag), but the embodiments of this specification are not limited thereto.

The reflective electrode 42 is disposed at a relatively lower position than the common light-emitting layer 5, allowing reflection of the light emitted from the common light-emitting layer 5 upwards. Here, the upward direction refers to the direction in which the user perceives the light, which may, for example, be the side where the encapsulation layer 8 or the color filter layer 9 is disposed. As a result, the first sub-pixel 21, second sub-pixel 22, and third sub-pixel 23 may achieve higher light efficiency compared to when the reflective electrode 42 is not present, and the user may perceive a high luminance, i.e., a sharper image, through the improved light efficiency.

The first reflective electrode 42a may be disposed on the first insulating layer 3a in the first emissive area EA1 and the first non-emissive area NEA1 of the first sub-pixel 21, the second reflective electrode 42b may be disposed on the first insulating layer 3a in the second emissive area EA2 and the second non-emissive area NEA2 of the second sub-pixel 22, and the third reflective electrode 42c may be disposed on the first insulating layer 3a in the third emissive area EA3 and the third non-emissive area NEA3 of the third sub-pixel 23. In each non-emissive area NEA1, NEA2, and NEA3, the first reflective electrode 42a and the first connection electrode 42a' may be electrically connected to each transistor 31, 32, and 33.

On top of the first reflective electrode 42a and the first connection electrode 42a', the second insulating layer 3b may be disposed. The second insulating layer 3b may reflect the step created by the thickness of the first reflective electrode 42a and the first connection electrode 42a'.

The second reflective electrode 42b may be disposed on the second insulating layer 3b. The second reflective electrode 42b may be disposed in the second sub-pixel 22. The second reflective electrode 42b may not overlap with the second transistor 32.

The third insulating layer 3c may be disposed on the second reflective electrode 42b. The third insulating layer 3c may reflect the step created by the thickness of the second reflective electrode 42b.

The third reflective electrode 42c and the second connection electrode 42c' may be disposed on the third insulating layer 3c. The third reflective electrode 42c may be disposed in the third sub-pixel 23, and the second connection electrode 42c' may be disposed in the first and second sub-pixels 21 and 22, respectively. The third reflective electrode 42c in the third sub-pixel 23 may be connected to the first connection electrode 42a' through the first contact hole CT1 in the third non-emissive area NEA3. The second connection electrode 42c' can be connected to the first reflective electrode 42a and the first connection electrode 42a' in the non-emissive areas NEA1 and NEA2, respectively, through the first contact hole CT1. The second reflective electrode 42b may be in a floating state, i.e., the second reflective electrode 42b is not connected to any connection electrode such as the first connection electrode or the second connection electrode.

A trench portion TRP may be formed in the insulating layer 3. For example, the trench portion TRP may be formed in the non-emissive areas NEA1, NEA2, and NEA3. As shown in FIG. 6 and FIG. 7, the trench portion TRP may be formed by penetrating parts of the third insulating layer 3c and the second insulating layer 3b, but the embodiments of this specification are not limited to this. In the display device 1 according to an embodiment, since a trench portion TRP is formed between adjacent sub-pixels 21, 22, and 23, lateral leakage current LLC caused by the common light-emitting layer 5 between adjacent sub-pixels 21, 22, and 23 can be improved.

As shown in FIG. 6, in the emission areas EA1, EA2, and EA3, the distance between the reflective electrodes 42a, 42b, and 42c and the cathode electrode 6 may differ from each other. For example, the distance between the first reflective electrode 42a and the cathode electrode 6 may be the largest, followed by the distance between the second reflective electrode 42b and the cathode electrode 6, with the distance between the third reflective electrode 42c and the cathode electrode 6 being the smallest.

In this way, the reflective electrodes 42a, 42b, and 42c are formed at various distances (or resonant distances) from the cathode electrode 6 because, depending on the spacing, the reflection and re-reflection between the reflective electrodes 42a, 42b, 42c and the cathode electrode 6 can enhance the light extraction efficiency of different colors of light. Therefore, in the first sub-pixel 21, the light extraction efficiency for red light may be enhanced, in the second sub-pixel 22, the light extraction efficiency for green light may be enhanced, and in the third sub-pixel 23, the light extraction efficiency for blue light may be enhanced.

The anode electrode 41 may include the first anode electrode 41a of the first sub-pixel 21, the second anode electrode 41b of the second sub-pixel 22, and the third anode electrode 41c of the third sub-pixel 23. The anode electrodes 41a, 41b, and 41c are disposed on the anode electrode layer, arranged in the same layer, and may include the same material.

In the third emissive area EA3 of the third sub-pixel 23, the third anode electrode 41c may be directly disposed on the third reflective electrode 42c. In the non-emissive areas NEA1 and NEA2 of the first and second sub-pixels 21 and 22, the anode electrodes 41a and 41b may be directly disposed on the second connection electrode 42c'.

Each of the anode electrodes 41a, 41b, and 41c may be electrically connected with the thin-film transistors 31, 32, and 33 in each non-emissive area NEA1, NEA2, and NEA3.

The anode electrodes 41a, 41b, and 41c may include materials with high light transmittance. For example, the anode electrodes 41a, 41b, and 41c may include ITO, IZO, or TiN, but are not limited thereto.

A bank BK may be disposed on the anode electrodes 41a, 41b, and 41c. The bank BK may be made of inorganic materials such as silicon nitride (SiNx), silicon oxide (SiOx), or aluminum oxide (Al₂O₃), but the embodiments in this specification are not limited to these materials. The bank BK may be disposed on the non-emissive areas NEA1, NEA2, and NEA3.

In the emissive areas EA1, EA2, and EA3, the bank BK may expose the upper surface of the anode electrodes 41a, 41b, and 41c to define the emissive areas EA1, EA2, and EA3. As shown in FIG. 6, the bank BK may be in contact with the upper surface and the side surface of the anode electrodes 41a, 41b, and 41c. As shown in FIG. 7, in the non-emissive areas NEA1, NEA2, and NEA3, the bank BK may cover the entire upper surface of the anode electrodes 41a, 41b, and 41c, and in the emissive areas EA1, EA2, and EA3, the bank BK may expose the upper surface of the anode electrodes 41a, 41b, and 41c.

The common light-emitting layer 5 is formed on the anode electrodes 41a, 41b, 41c and the bank BK. The common light-emitting layer 5 may contact the upper surface of the anode electrodes 41a, 41b, 41c. The common light-emitting layer 5 may directly contact the upper surface of the anode electrodes 41a, 41b, 41c, the upper and side surfaces of the bank BK, and the side surface of the insulating layer 3. The common light-emitting layer 5 may also extend into the trench portion TRP.

According to one embodiment, the organic light-emitting device OLED may include the first electrode 4, ANO, the cathode electrode 6, CAT, and the common light-emitting layer 5 between the first electrode 4 and the cathode electrode 6.

The common light-emitting layer 5 may be configured to emit white (W) light. To achieve this, the common light-emitting layer 5 may include a plurality of stacks that emit light of different colors. Specifically, the common light-emitting layer 5 may include a first stack, a second stack, and a charge generation layer CGL disposed between the first stack and the second stack.

The cathode electrode 6 is formed on the common light-emitting layer 5. The cathode electrode 6 may function as the cathode of the display device 1. The cathode electrode 6 is formed in each of the sub-pixels 21, 22, and 23 and between the sub-pixels 21, 22, and 23, similar to the common light-emitting layer 5.

In an embodiment, the display device 1 may have a cathode electrode 6 made of a semi-transparent electrode to implement white light with high light efficiency in the top emission configuration. As a result, micro cavity effects may be obtained for each of the first to third sub-pixels 21, 22, and 23. The micro cavity effect may be achieved by repeated reflection and re-reflection of light between the cathode electrode 6 and the reflective electrode 42, which improves light extraction efficiency.

Meanwhile, since the cathode electrode 6 is formed on the upper surface of the common light-emitting layer 5, it may be shaped according to the profile of the common light-emitting layer 5. Since the common light-emitting layer 5 is formed following the profile of the first electrode 4 in the light-emitting region, the cathode electrode 6 may ultimately be formed to follow the profile of the first electrode 4. Additionally, the capping layer 7 on the cathode electrode 6 may also be formed to follow the profile of the cathode electrode 6.

The capping layer 7 may be made of an inorganic insulating material, but is not limited thereto. The capping layer 7 may be disposed on the cathode electrode 6 to protect the organic light-emitting device (OLED).

The encapsulation layer 8 is formed on the cathode electrode 6 to prevent external moisture from penetrating into the common light-emitting layer 5. This encapsulation layer 8 may be made of an inorganic insulating material or may be formed in an alternating stack structure of inorganic and organic insulating materials, but is not limited to these configurations.

The color filter layer 9 is formed on the encapsulation layer 8. The color filter layer 9 may include a first color filter 91 of red (R) provided in the first sub-pixel 21, a second color filter 92 of green (G) provided in the second sub-pixel 22, and a third color filter 93 of blue (B) provided in the third sub-pixel 23, but is not limited to these configurations.

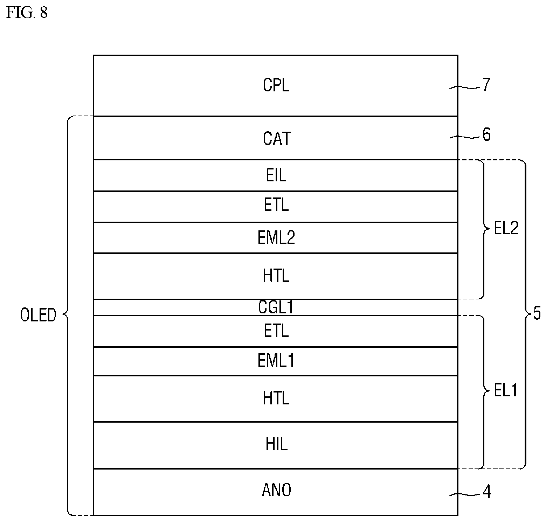

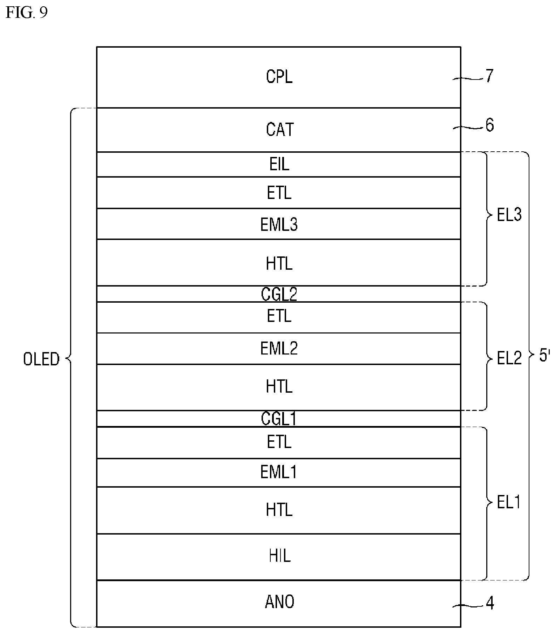

FIG. 8 is a cross-sectional view of the organic light-emitting device in FIG. 6. FIG. 9 is a cross-sectional view of the organic light-emitting element of FIG. 6 according to an alternative embodiment.

Referring to FIGS. 1 to 8, the common light-emitting layer 5 may be formed to include the first stack EL1, second stack EL2, and first charge generation layer CGL1 provided on the first electrode 4.

The first stack EL1 is provided on the first electrode 4 and may have a structure where a hole injecting layer HIL, a hole transporting layer HTL, a blue (B) emitting layer EML1, and an electron transporting layer ETL are sequentially stacked.

The first stack EL1 may be disposed between the first sub-pixel 21 and the second sub-pixel 22, as well as between the second sub-pixel 22 and the third sub-pixel 23.

The first charge generation layer CGL1 serves to supply charges to the first stack EL1 and the second stack EL2. The first charge generation layer CGL1 may include an N-type charge generation layer that supplies electrons to the first stack EL1 and a P-type charge generation layer that supplies holes to the second stack EL2. The N-type charge generation layer may be made by doping a metal material.

The second stack EL2 is provided on the first stack EL1 and may have a structure where a hole transporting layer HTL, a yellow-green (YG) emitting layer EML2, an electron transporting layer ETL, and an electron injecting layer EIL are sequentially stacked.

The second stack EL2 may be disposed between the first sub-pixel 21 and the second sub-pixel 22, as well as between the second sub-pixel 22 and the third sub-pixel 23.

As a result, the common light-emitting layer 5 may be provided as a common layer across the entire first to third sub-pixels 21, 22, and 23, as shown in FIGS. 6 and 7.

As shown in FIG. 9, the common light-emitting layer 5' of the organic light-emitting device (OLED) according to an embodiment may include the first stack EL1, the second stack EL2, the third stack EL3, the first charge generation layer CGL1 between the first stack EL1 and the second stack EL2, and the second charge generation layer CGL2 between the second stack EL2 and the third stack EL3, provided on the first electrode 4.

The first stack EL1 is provided on the first electrode 4 and may have a structure where a hole injecting layer HIL, a hole transporting layer HTL, a blue (B) emitting layer EML1, and an electron transporting layer ETL are sequentially stacked.

The first stack EL1 may be disposed between the first sub-pixel 21 and the second sub-pixel 22, as well as between the second sub-pixel 22 and the third sub-pixel 23, that is, on the bank BK.

The first charge generation layer CGL1 serves to supply charges to the first stack EL1 and the second stack EL2. The first charge generation layer CGL1 may include an N-type charge generation layer that supplies electrons to the first stack EL1 and a P-type charge generation layer that supplies holes to the second stack EL2. The N-type charge generation layer may be made by doping a metal material.

The second stack EL2 is provided on the first stack EL1 and may have a structure where a hole transporting layer HTL, a green (G) emitting layer EML2, and an electron transporting layer ETL are sequentially stacked.

The second stack EL2 may be disposed between the first sub-pixel 21 and the second sub-pixel 22, as well as between the second sub-pixel 22 and the third sub-pixel 23, i.e., on the bank BK.

The second charge generation layer CGL2 serves to supply charge to the second stack EL2 and the third stack EL3. The second charge generation layer CGL2 may include an N-type charge generation layer to supply electrons to the second stack EL2 and a P-type charge generation layer to supply holes to the third stack EL3. The N-type charge generation layer may be made by doping a metal material.

The third stack EL3 is provided on the second stack EL2 and may have a structure where a hole transporting layer HTL, a red (R) emitting layer EML3, an electron transporting layer ETL, and an electron injecting layer EIL are sequentially stacked.

As shown in FIGS. 1 to 9, the charge generation layer CGL1, CGL2 may be disposed between the first sub-pixel 21 and the second sub-pixel 22, and between the second sub-pixel 22 and the third sub-pixel 23. Meanwhile, in the display device 1 according to an embodiment, since the common light-emitting layer 5 is disposed between each of the sub-pixels 21, 22, and 23, lateral leakage current may occur through the charge generation layers CGL1 and CGL2 to adjacent sub-pixels 21, 22, and 23 when any one of the sub-pixels emits light; however, a trench portion TRP may be formed between the sub-pixels 21, 22, and 23. The formation length of the common light-emitting layer 5 at the boundary of the sub-pixels 21, 22, and 23 may increase through the trench portion TRP, thereby lengthening the current path. As a result, side leakage current can be prevented. Furthermore, by separating the common light-emitting layer 5 in the trench portion TRP, side leakage current can be prevented in advance.

Referring again to FIGS. 6 and 7, the cathode electrode 6 is formed on the common light-emitting layer 5, the encapsulation layer 8 is formed on the cathode electrode 6, and the color filter layer 9 is formed on the encapsulation layer 8.

Although not shown in the drawings, a black matrix may be provided between the first to third color filters 91, 92, and 93 to prevent color mixing between sub-pixels.

In the display device 1 according to an embodiment, a second reflective conductive layer may not be disposed in the region overlapping with the contact portion (the transistors 31, 32, 33 in FIG. 7). That is, the second reflective electrode 42b may not be disposed in the contact portion. As a result, the anode electrodes 41a, 41b, and 41c of each sub-pixel 21, 22, and 23 may be connected to the transistors 31, 32, and 33 through the third reflective conductive layer and the first reflective conductive layer. That is, by reducing the number of conductive layers (or electrodes) at the contact portion (omitting the second reflective conductive layer), the step difference at the contact portion can be alleviated. This can minimize the thickness variation of the common light-emitting layer 5 at the contact portion. For example, when three or more reflective conductive layers are disposed at the contact portion, the insulating layer 3 may reflect the step difference caused by the thickness of the conductive layers (or electrodes) disposed beneath, which may cause a thickness variation in the common light-emitting layer 5 at the contact portion. In this case, a color deviation may occur between the light emitted from the common light-emitting layer 5 in the non-emissive areas NEA1, NEA2, and NEA3 and the light emitted from the common light-emitting layer 5 in the emissive areas EA1, EA2, and EA3. Although a bank BK is disposed in the non-emissive areas NEA1, NEA2, and NEA3, some light may pass through the bank BK, which may lower the color purity of each sub-pixel 21, 22, and 23 when viewed from the outside, thereby reducing the luminous efficiency of the organic light-emitting device (OLED).

However, according to an embodiment, since the step difference at the contact portion is alleviated, the luminous efficiency of the OLED can be improved, and abnormal color deviation can be minimized.

Furthermore, as shown in FIG. 7, since the number of conductive layers (or electrodes) at the contact portion overlapping with the transistors 31, 32, and 33 is reduced, and the number of contact holes is minimized, the area of the emissive areas EA1, EA2, and EA3 can be expanded.

Hereinafter, descriptions of display devices according to other embodiments will be provided. In explaining the following embodiments, detailed descriptions of configurations that are the same as or similar to those described with reference to FIGS. 1 to 9 will be omitted to avoid redundancy.

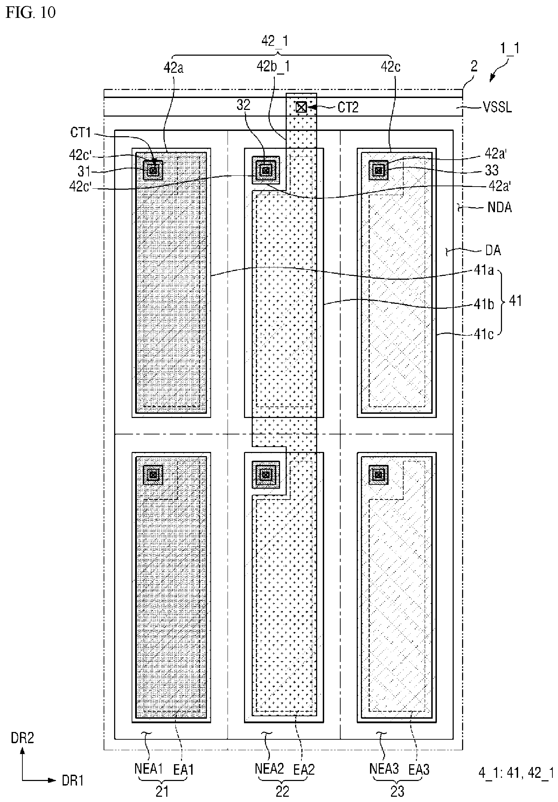

FIG. 10 is a plan view of a pixel according to another embodiment.

The display device 1_1 according to the embodiment of FIG. 10 differs from the display device 1 according to the embodiment of FIG. 5 in that a fixed voltage is applied to the second reflective electrode 42b_1 of the first electrode 42_1 of the second sub-pixel 22.

More specifically, in this embodiment, a low-potential voltage line VSSL may be arranged in the non-display area NDA of the substrate 2. The second reflective electrode 42b_1 of the second sub-pixel 22 may be electrically connected to the low-potential voltage line VSSL through the second contact hole CT2. Each of the sub-pixels 21, 22, and 23 in this embodiment may be repeatedly disposed along the second direction DR2. For example, the second reflective electrode 42b_1 of the second sub-pixel 22 located in the first row of FIG. 10 and the second reflective electrode 42b_1 of the second sub-pixel 22 located in the second row may be physically connected. That is, the second reflective electrodes 42b_1 of all the second sub-pixels 22 may be supplied with a low-potential voltage EVSS (FIG. 4) in this embodiment.

In some embodiments, the second reflective electrode 42b_1 of the second sub-pixel 22 may be connected to the reference voltage line RL (FIG. 4). Therefore, the second reflective electrode 42b_1 may be supplied with the reference voltage VREF (FIG. 4).

According to this embodiment, since the fixed voltage (EVSS or VREF) applied to the second reflective electrode 42b_1, there is an advantage in that the voltage of the second reflective electrode 42b_1 can be stabilized, thereby preventing defects in the operation of the organic light-emitting device OLED (FIG. 4) from occurring in advance.

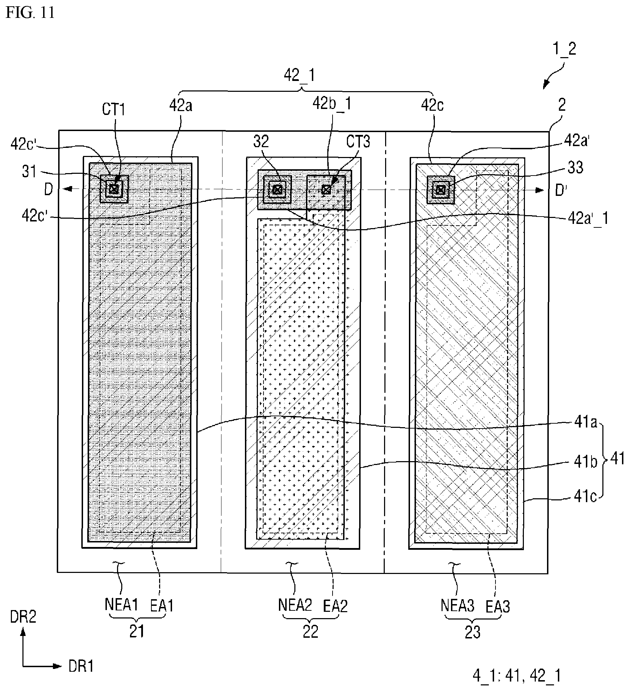

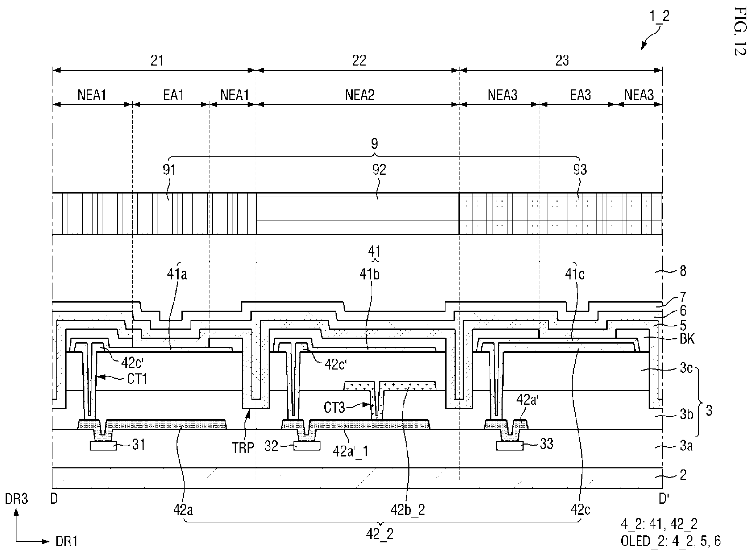

FIG. 11 is a plan view of a pixel according to another embodiment. FIG. 12 is a cross-sectional view taken along line D-D' of FIG. 11.

The display device 1_2 according to the embodiment of FIGS. 11 and 12 differs from the display device 1 according to the embodiment of FIGS. 5 and 7 in that the first electrode 4_2 includes a reflective electrode 42_2.

More specifically, the reflective electrode 42_2 includes a second reflective electrode 42b_2, and in the second sub-pixel 22, the second reflective electrode 42b_2 may overlap with the first connection electrode 42a'_1. The area of the second non-emissive region NEA2 in the second sub-pixel 22 may be larger than that of the second non-emissive region NEA2 in FIGS. 5 and 7.

In the second sub-pixel 22, the first connection electrode 42a'_1 may be electrically connected to the second reflective electrode 42b_2 via the third contact hole CT3. The bank BK may cover the second reflective electrode 42b_2.

According to this embodiment, the second reflective electrode 42b_2 is electrically connected to the first connection electrode 42a'_1, thereby stabilizing the voltage of the second reflective electrode 42b_2, which can prevent any malfunction in driving the organic light-emitting device OLEO_2.

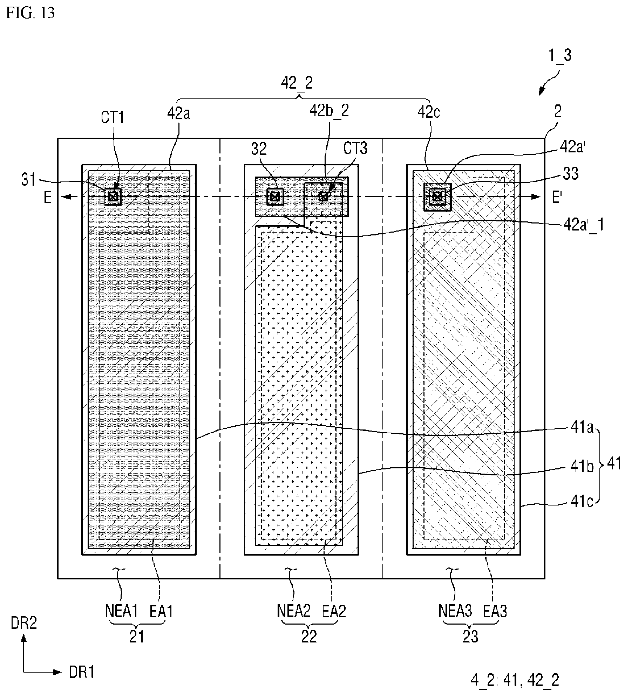

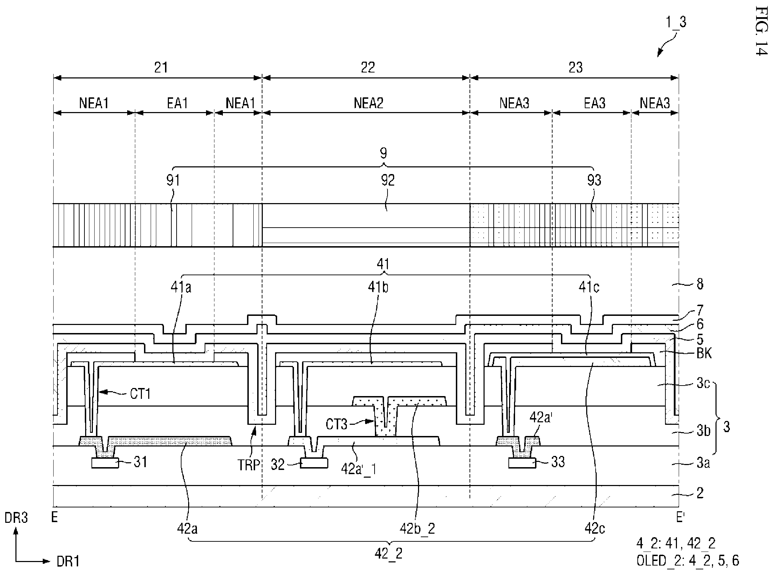

FIG. 13 is a plan view of a pixel according to another embodiment. FIG. 14 is a cross-sectional view taken along line E-E' of FIG. 13.

The display device 1_3 according to the embodiment of FIGS. 13 and 14 differs from the display device 1_2 according to the embodiment of FIGS. 11 and 12 in that the anode electrodes 41a, 41b, and 41c of each sub-pixel 21, 22, and 23 are directly connected to the first reflective electrode 42a or the first connection electrode 42a'_1, 42a'.

Specifically, in the first sub-pixel 21, the second connection electrode is omitted, and the first anode electrode 41a is directly connected to the first reflective electrode 42a through the first contact hole CT1; in the second sub-pixel 22, the third connection electrode is omitted, and the second anode electrode 41b is directly connected to the first connection electrode 42a'_1 through the first contact hole CT1, while the second reflective electrode 42b_2 is directly connected to the first connection electrode 42a'_1 through the third contact hole CT3. In the third sub-pixel 23, the third reflective electrode 42c is directly connected to the first connection electrode 42a' through the first contact hole CT1.

According to this embodiment, the second reflective conductive layer may not be disposed in the area overlapping with the contact portions (transistors 31, 32, and 33 in FIG. 14). That is, the second reflective electrode 42b_2 may not be disposed in the contact portion. As a result, the anode electrodes 41a, 41b, and 41c of each sub-pixel 21, 22, and 23 may be connected to the transistors 31, 32, and 33 through the first reflective conductive layer. That is, by reducing the number of conductive layers (or electrodes) at the contact portion connected to the transistors 31, 32, and 33 (by omitting the second reflective conductive layer), the step difference at the contact portion can be alleviated. This can minimize the thickness variation of the common light-emitting layer 5 at the contact portion. Furthermore, because the step difference in the contact portion is alleviated, the light-emitting efficiency of the organic light-emitting device OLED_2 can be improved, and the color deviation can be minimized.

The additional description that has already been made with reference to FIGS. 11 and 12 will be omitted.

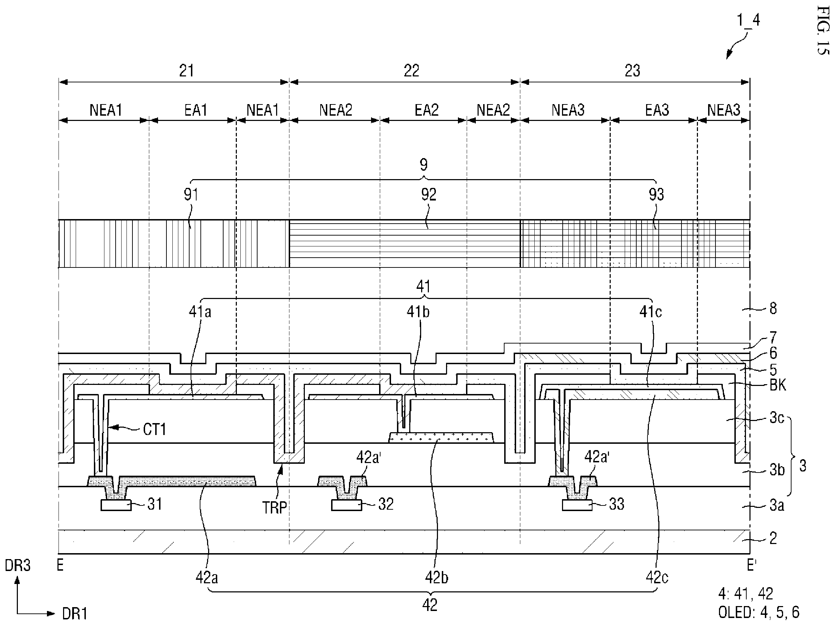

FIG. 15 is a cross-sectional view of a display device according to another embodiment.

The display device 1_4 according to the embodiment of FIG. 15 differs from the display device 1_3 according to the embodiment of FIG. 14 in that the second reflective electrode 42b of the second sub-pixel 22 maintains a floating state, i.e., the second reflective electrode 42b is not connected to any connection electrode such as the first connection electrode or the second connection electrode, eliminating the third contact hole CT3.

In some embodiments, the second reflective electrode 42b of the second sub-pixel 22 is connected to the low-potential voltage line VSSL as shown in FIG. 10, omitting the third contact hole CT3.

Other explanations are omitted as they have been detailed above with reference to FIG. 14.

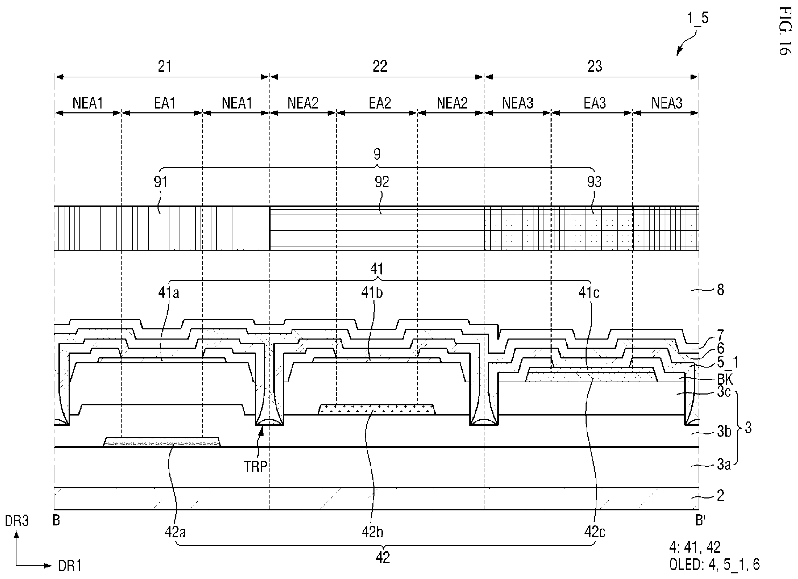

FIG. 16 is a cross-sectional view of a display device according to another embodiment.

The display device 1_5 according to the embodiment of FIG. 16 differs from the display device 1 according to the embodiment of FIG. 6 in that the common light-emitting layer 5_1 is included.

More specifically, the common light-emitting layer 5_1 may be physically separated at the boundaries between adjacent sub-pixels 21, 22, and 23.

For example, the common light-emitting layer 5_1 may be physically separated in the non-emission areas NEA1, NEA2, and NEA3. The common light-emitting layer 5_1 may be physically separated in the non-emission areas NEA1, NEA2, and NEA3 by a trench portion TRP.

For example, the common light-emitting layer 5_1 may be divided into portions that are placed on the side surfaces of the insulating layers 3 in the non-emission areas NEA1, NEA2, and NEA3 and on the side surfaces of the bank BK, as well as portions placed on the upper surface of the insulating layer 3 in the trench portion TRP formed in the non-emission areas NEA1, NEA2, and NEA3. The portions placed on the side surfaces of the insulating layers 3 in the non-emission areas NEA1, NEA2, and NEA3 and on the side surfaces of the bank BK are physically separated from the portions placed on the upper surface of the insulating layer 3 in the trench portion TRP.

According to the display device 1_5 of this embodiment, the common light-emitting layer 5_1 may be physically separated between adjacent sub-pixels 21, 22, and 23, and in each non-emission area NEA1, NEA2, and NEA3, the common light-emitting layer 5_1 may be physically separated at the same level. This leads to an improvement in the lateral leakage current LLC caused by the common light-emitting layer 5_1.

Other explanations are omitted as they have been detailed above with reference to FIG. 6.

The display device according to various embodiments of this specification may be described as follows.

A display device according to various embodiments of this specification includes a substrate including a first sub-pixel, a second sub-pixel, and a third sub-pixel, each including an emissive area and a non-emissive area surrounding the emissive area; a first conductive layer including a first reflective electrode in the emissive area and the non-emissive area of the first sub-pixel on the substrate, and first connection electrodes in the non-emissive areas of the second and third sub-pixels; a second conductive layer including a second reflective electrode in the emissive area of the second sub-pixel on the first conductive layer; a third conductive layer including a third reflective electrode in the emissive area and the non-emissive area of the third sub-pixel on the second conductive layer, and a second connection electrode in the non-emissive areas of the first and second sub-pixels; and anode electrodes disposed on the third conductive layer in the first, second and third sub-pixels, wherein, in the non-emissive area of the first sub-pixel, the second connection electrode is connected to the first reflective electrode, in the non-emissive area of the second sub-pixel, the second connection electrode is connected to the first connection electrode, and in the non-emissive area of the third sub-pixel, the third reflective electrode is connected to the first connection electrode. In addition, a display device according to varios embodiments includes a substrate including a first sub-pixel, a second sub-pixel, and a third sub-pixel, each including an emissive area and a non-emissive area surrounding the emissive area; a first conductive layer including a first reflective electrode in the emissive area and the non-emissive area of the first sub-pixel on the substrate, and a first connection electrode in the non-emissive areas of the second and third sub-pixels; a second conductive layer including a second reflective electrode in the emissive area of the second sub-pixel above the first conductive layer; a third conductive layer including a third reflective electrode in the emissive area and the non-emissive area of the third sub-pixel above the second conductive layer, and a second connection electrode in the non-emissive areas of the first and second sub-pixels; and anode electrodes respectively disposed on the first, the second, and the third conductive layers in the first, second and third sub-pixels. In the non-emissive area of the first sub-pixel, the second connection electrode is connected to the first reflective electrode, in the non-emissive area of the second sub-pixel, the second connection electrode is connected to the first connection electrode, and in the non-emissive area of the third sub-pixel, the third reflective electrode is connected to the first connection electrode.

In the display device according to various embodiments of this specification, in the non-emissive area of the first sub-pixel, the second connection electrode is directly connected to the first reflective electrode, and in the non-emissive area of the second sub-pixel, the second connection electrode is directly connected to the first connection electrode.

In the display device according to various embodiments of this specification, in the non-emissive area of the third sub-pixel, the third reflective electrode is directly connected to the first connection electrode.

In the display device according to various embodiments of this specification, in the non-emissive areas of the first sub-pixel and the second sub-pixel, the anode electrode is directly disposed on the second connection electrode.

In the display device according to various embodiments of this specification, in the emissive area and the non-emissive area of the third sub-pixel, the anode electrode is directly disposed on the third reflective electrode.

In the display device according to various embodiments of this specification, the second reflective electrode is floating or in a floating state, i.e., the second reflective electrode is not connected to any connection electrode such as the first connection electrode or the second connection electrode.

In the display device according to various embodiments of this specification, the second reflective electrode is applied with a fixed voltage.

The display device according to various embodiments of this specification further includes a display area in which the first, second and third sub-pixels are disposed, a non-display area surrounding the display area, and a low-potential voltage line disposed in the non-display area, wherein the second reflective electrode is electrically connected to the low-potential voltage line.

In the display device according to various embodiments of this specification, the first, second and third sub-pixels are arranged along a first direction, each of the first, second and third sub-pixels is repeatedly disposed along a second direction intersecting the first direction, and adjacent second sub-pixels in the second direction share the second reflective electrode.

In the display device according to various embodiments of this specification, the second reflective electrode does not overlap with the first connection electrode or the second connection electrode.

In the display device according to various embodiments of this specification, in the second sub-pixel, the second reflective electrode overlaps with the first connection electrode.

In the display device according to various embodiments of this specification, the second reflective electrode is connected to the first connection electrode.

A display device according to various embodiments of this specification includes a substrate including a first sub-pixel, a second sub-pixel, and a third sub-pixel, each including an emissive area and a non-emissive area surrounding the emissive area; a first conductive layer including a first reflective electrode in the emissive area and the non-emissive area of the first sub-pixel on the substrate, and first connection electrodes in the non-emissive areas of the second and third sub-pixels; a second conductive layer including a second reflective electrode in the emissive area of the second sub-pixel on the first conductive layer; a third conductive layer including a third reflective electrode in the emissive area and the non-emissive area of the third sub-pixel on the second conductive layer; and anode electrodes respectively disposed on the first, second and third conductive layers in the first, second and third sub-pixels, wherein, in the non-emissive area of the first sub-pixel, the anode electrode is directly connected to the first reflective electrode, in the non-emissive area of the second sub-pixel, the anode electrode is directly connected to the first connection electrode, and in the non-emissive area of the third sub-pixel, the third reflective electrode is directly connected to the first connection electrode. In addition, a display device includes a substrate including a first sub-pixel, a second sub-pixel, and a third sub-pixel, each including an emissive area and a non-emissive area surrounding the emissive area; a first conductive layer including a first reflective electrode in the emissive area and the non-emissive area of the first sub-pixel on the substrate, and a first connection electrode in the non-emissive areas of the second and third sub-pixels; a second conductive layer including a second reflective electrode in the emissive area of the second sub-pixel above the first conductive layer; a third conductive layer including a third reflective electrode in the emissive area and the non-emissive area of the third sub-pixel above the second conductive layer; and anode electrodes respectively disposed on the first, second and third conductive layers in the first, second and third sub-pixels. In the non-emissive area of the first sub-pixel, the anode electrode is directly connected to the first reflective electrode, in the emissive area of the second sub-pixel, the anode electrode is directly connected to the second reflective electrode, and in the non-emissive area of the third sub-pixel, the third reflective electrode is directly connected to the first connection electrode.

In the display device according to various embodiments of this specification, in the emissive area and the non-emissive area of the third sub-pixel, the anode electrode is directly disposed on the third reflective electrode.

In the display device according to various embodiments of this specification, the second reflective electrode is floating or in a floating state, i.e., the second reflective electrode is not connected to any connection electrode such as the first connection electrode or the second connection electrode.

In the display device according to various embodiments of this specification, the second reflective electrode is applied with a fixed voltage.

The display device according to various embodiments of this specification further includes a display area in which the first, second and third sub-pixels are disposed, a non-display area surrounding the display area, and a low-potential voltage line disposed in the non-display area, wherein the second reflective electrode is electrically connected to the low-potential voltage line.

In the display device according to various embodiments of this specification, the first, second and third sub-pixels are arranged along a first direction, each of the first, second and third sub-pixels is repeatedly disposed along a second direction intersecting the first direction, and adjacent second sub-pixels in the second direction share the second reflective electrode.

In the display device according to various embodiments of this specification, the second reflective electrode does not overlap with the first connection electrode or the second connection electrode.

In the display device according to various embodiments of this specification, in the second sub-pixel, the second reflective electrode overlaps with the first connection electrode, and the second reflective electrode is connected to the first connection electrode.

The embodiments are advantageous for omitting the second connection electrode, located on the same layer as the second reflective electrode, in the non-emissive areas of the first and third sub-pixels, allowing the anode electrode of the first sub-pixel to connect to the transistor via the third connection electrode and the first reflective electrode, and the anode electrode of the third sub-pixel to connect to the transistor via the third connection electrode and the first connection electrode. The embodiments are advantageous for omitting the extension of the second reflective electrode in the non-emissive area of the second sub-pixel, allowing the anode electrode of the second sub-pixel to connect to the transistor via the third connection electrode and the first connection electrode. The embodiments are advantageous for mitigating the step difference in the contact portion by reducing the number of conductive layers (or electrodes) in the contact portion connected to the transistor. The embodiments are advantageous for minimizing the thickness variation of the common light-emitting layer in the contact portion as a result of the mitigated step difference.

The embodiments are advantageous for improving the light emission efficiency of the organic light-emitting device and minimizing abnormal color deviation in the contact portion by minimizing the thickness variation of the common light-emitting layer in the contact portion.

The embodiments are advantageous for expanding the area of the light-emitting region by reducing the number of contact portions connected to the transistor.

The embodiments are advantageous for stabilizing the voltage of the second reflective electrode by connecting the second reflective electrode of the second sub-pixel to a low-voltage power line or a reference voltage line.

The embodiments are advantageous for providing a display device with high color reproducibility by improving the occurrence of color deviation in the non-emissive area.

However, the effects achievable through this specification are not limited to the aforementioned, and additional effects not explicitly described herein may be readily understood by those skilled in the art based on the disclosure.

While the embodiments have been described with reference to the attached drawings, it will be understood by those skilled in the art that the embodiments described above are exemplary and not limited in all respects. Moreover, the scope of the embodiments is determined by the claims that follow, rather than by the detailed description.

### DESCRIPTION OF REFERENCE NUMERALS

1: display device
2: substrate
3: insulating layer
4: first electrode
5: common light-emitting layer
6: cathode electrode
7: capping layer
8: encapsulation layer
9: color filter layer
BK: bank

## Claims

1. A display device (1) comprising:
a substrate (2) including a first sub-pixel (21), a second sub-pixel (22), and a third sub-pixel (23), each including an emissive area (EA1, EA2, EA3) and a non-emissive area (NEA1, NEA2, NEA3) surrounding the emissive area (EA1, EA2, EA3);
a first conductive layer including a first reflective electrode (42a) in the emissive area (EA1) and the non-emissive area (NEA1) of the first sub-pixel (21) on the substrate (2), and a first connection electrode (42a') respectively in the non-emissive areas (NEA2, NEA3) of the second and third sub-pixels (22, 23);
a second conductive layer including a second reflective electrode (42b) in the emissive area (EA2) of the second sub-pixel (22) on the first conductive layer;
a third conductive layer including a third reflective electrode (42c) in the emissive area (EA3) and the non-emissive area (NEA3) of the third sub-pixel (23) on the second conductive layer,; and
anode electrodes (41, 41a, 41b, 41c) respectively disposed on the third conductive layer in the first, second and third sub-pixels (21, 22, 23),
wherein, in the non-emissive area (NEA1) of the first sub-pixel (21), the anode electrode (41a) is connected to the first reflective electrode (42a),
in the non-emissive area (NEA2) of the second sub-pixel (22), the anode electrode (41b) is connected to the first connection electrode (42a'), and
in the non-emissive area (NEA3) of the third sub-pixel (23), the third reflective electrode (42c) is connected to the first connection electrode (42a').

2. The display device (1) of claim 1, wherein the third conductive layer includes a second connection electrode (42c') in the non-emissive areas (NEA1, NEA2) of the first and second sub-pixels (21, 22), and
in the non-emissive area (NEA1) of the first sub-pixel (21), the anode electrode (41a) is connected to the first reflective electrode (42a) by the second connection electrode (42c'), and/or
in the non-emissive area (NEA2) of the second sub-pixel (22), the anode electrode (41b) is connected to the first connection electrode (42a') by the second connection electrode (42c').

3. The display device (1) of claim 2, wherein, in the non-emissive area (NEA1) of the first sub-pixel (21), the second connection electrode (42c') is directly connected to the first reflective electrode (42a); and/or
in the non-emissive area (NEA2) of the second sub-pixel (22), the second connection electrode (42c') is directly connected to the first connection electrode (42a').

4. The display device of claim 2 or 3, wherein, in the non-emissive areas (NEA1, NEA2) of the first sub-pixel (21) and the second sub-pixel (22), the anode electrode (41a, 41b) is directly disposed on the second connection electrode (42c').

5. The display device according to any one of the preceding claims, wherein, in the non-emissive area (NEA3) of the third sub-pixel (23), the third reflective electrode (42c) is directly connected to the first connection electrode (42a').

6. The display device (1) according to any one of the preceding claims, wherein, in the emissive area (EA3) and the non-emissive area (NEA3) of the third sub-pixel (23), the anode electrode (41c) is directly disposed on the third reflective electrode (42c).

7. The display device according to any one of the preceding claims, wherein the second reflective electrode (42b) is floating, or wherein the second reflective electrode (42b) is applied with a fixed voltage.

8. The display device (1) according to any one of the preceding claims, further comprising a display area (DA) in which the first, second and third sub-pixels (21, 22, 23) are disposed, a non-display area (NDA) surrounding the display area (DA), and a low-potential voltage line (VSSL) disposed in the non-display area (NDA),
wherein the second reflective electrode (42b) is electrically connected to the low-potential voltage line (VSSL).

9. The display device (1) of claim 8, wherein the first, second and third sub-pixels (21, 22, 23) are arranged along a first direction (DR1), each of the first, second and third sub-pixels (21, 22, 23) is repeatedly disposed along a second direction (DR2) intersecting the first direction (DR1), and adjacent second sub-pixels (22) in the second direction (DR2) share the second reflective electrode (42b).

10. The display device (1) according to any one of the preceding claims, wherein the second reflective electrode (42b) does not overlap with the first connection electrode (42a') or the second connection electrode (42c').

11. The display device according to any one of the preceding claims 1 to 9, wherein, in the second sub-pixel (22), the second reflective electrode (42b_2) overlaps with the first connection electrode (42a'_1).

12. The display device of claim 11, wherein the second reflective electrode (42b_2) is connected to the first connection electrode (42a'_1).

13. The display device according to any one of the preceding claims, wherein, in the second sub-pixel, the second reflective electrode overlaps with the first connection electrode, and the second reflective electrode is connected to the first connection electrode.

14. The display device (1_4) according to any one of the preceding claims, further comprising a common light-emitting layer (5) disposed on the anode electrodes (41a, 41b, 41c) in the first, second and third sub-pixels (21, 22, 23),
wherein the common light-emitting layer (5) is physically separated at boundaries between adjacent sub-pixels.
